Europäisches Patentamt

European Patent Office

Office européen des brevets

(19)

(11) **EP 1 058 393 A1**

## (12) DEMANDE DE BREVET EUROPEEN

(43) Date de publication:
**06.12.2000 Bulletin 2000/49**

(51) Int Cl.$^7$: **H03M 13/35**, H04L 1/00

(21) Numéro de dépôt: **00401522.8**

(22) Date de dépôt: **30.05.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **02.06.1999 FR 9906954**

(71) Demandeur: **FRANCE TELECOM**
**75015 Paris (FR)**

(72) Inventeur: **Tortelier, Patrick**
**92110 Paris (FR)**

(74) Mandataire: **Fréchède, Michel**
**Cabinet Plasseraud**
**84, rue d'Amsterdam**
**F-75440 Paris Cédex 09 (FR)**

(54) **Procédé de détection en aveugle du mode de codage de données numériques**

(57) L'invention concerne un procédé de détection en aveugle du mode de codage de données numériques.

Les données étant transmises par trames de n bits, soumises partiellement à un codage convolutif, on calcule (1000) sur une suite de bits une valeur de syndrome souple représentative de la probabilité d'erreur de transmission de ces bits, puis à partir de la moyenne m et de l'écart type σ de la distribution des valeurs absolues de syndrome souple, une valeur de vraisemblance V(α,β) (1001), α, β désignant le nombre de bits codés respectivement non codés. Une maximisation (1002) de la valeur de vraisemblance V(α,β) en fonction de α ou β permet (1003) de discriminer le mode de codage à partir des valeurs α ou β correspondantes.

Application à l'optimisation du codage de signaux numériques.

FIG.2.

**Description**

L'invention concerne un procédé de détection en aveugle du mode de codage de données numériques, applicable à la transmission de signaux de parole codés sur un canal radio-mobile.

A l'heure actuelle, les applications de transmission de la parole à débit réduit sur un canal radio-mobile, telles que par exemple la transmission de ce type de signaux à 13 kbits/s du codeur de parole GSM, nécessitent une protection de l'information transmise, d'une part, parce que le canal de transmission est de qualité médiocre, et, d'autre part, parce que les erreurs de transmission présentent, pour l'auditeur, un effet subjectif très rapidement désagréable sur le signal audionumérique.

Le débit en ligne étant fixé à 22,8 kbits/s, pour la transmission GSM à plein débit, ou à 11,4 kbits/s pour la transmission GSM à demi débit, on utilise le fait que tous les bits d'une trame de données issue du vocodeur n'ont pas la même importance subjective pour protéger seulement une partie de cette trame par un codage de type codage convolutif. Actuellement, les 260 bits d'une trame de parole à plein débit sont répartis en deux classes de protection : 182 bits de cette trame sont protégés par un codage convolutif de rendement ½ et les 78 bits restants sont transmis sans protection, ces derniers bits étant jugés les moins sensibles. Ce partage en deux classes de protection est figé et ne dépend pas de la qualité du canal radio de transmission.

La présente invention a pour objet la mise en oeuvre d'un procédé de détection en aveugle, à la réception, du mode de codage de données numériques, de façon à permettre à l'émission, c'est-à-dire au niveau du processus de codage, d'effectuer une adaptation du partage du débit global, supposé constant, entre vocodeur et codage de canal, de manière que lorsque le canal de transmission est bon, on augmente le débit du codeur de parole, au niveau du vocodeur, et l'on diminue celui du codage de canal, l'introduction d'une forte redondance par codage convolutif n'étant pas indispensable, afin d'améliorer la qualité audiofréquence du signal transmis, mais, qu'inversement, lorsque le canal est mauvais, on bascule vers un mode de codage dans lequel la qualité intrinsèque du codage au niveau du vocodeur est réduite au profit du codage de canal. Un tel mode opératoire permet d'envisager le maintien de la continuité de la liaison radiofréquence, avec une qualité audiofréquence moins bonne toutefois.

En conséquence, et conformément à l'objet de la présente invention, celle-ci vise à fournir au niveau de tout récepteur un procédé permettant la détection en aveugle du mode de codage de données numériques, parmi un nombre déterminé de modes de codage, de type convolutif, chaque mode de codage pouvant être caractérisé, et discriminé, à partir du nombre de bits codés respectivement non codés de chaque trame constitutive du signal audionumérique.

Un autre objet de la présente invention est en outre la mise en oeuvre d'un procédé de détection en aveugle du mode de codage de données numériques permettant d'éviter toute transmission du mode de codage utilisé vers le récepteur, au moyen d'un certain nombre de bits, ce type de mode opératoire mobilisant un certains nombre de bits inutilisables pour la transmission des données dans les trames successives et devant en outre être soumis à une protection par codage convolutif très robuste vis-à-vis des erreurs de transmission, sauf à introduire un risque inacceptable de tentative de décodage à partir d'informations erronées relatives au mode de codage utilisé.

Le procédé de détection en aveugle d'un mode de codage de données numériques transmises par trames, objet de la présente invention, chaque trame courante comportant n bits et consistant en un premier nombre déterminé de bits codés par codage et un deuxième nombre déterminé de bits non codés, le nombre de bits codés et le nombre de bits non codés définissant le mode de codage étant choisi parmi un ensemble fini de possibilités, est remarquable en ce qu'il consiste, pour au moins une trame transmise, à calculer, sur une suite de bits, une valeur de syndrome souple représentative de la probabilité d'erreur de transmission pour les bits considérés, à calculer à partir des paramètres de moyenne et d'écart type de la distribution de ces valeurs de syndrome souple une valeur de vraisemblance, fonction du nombre de bits codés a ou non codés $\beta = n-\alpha$, pour que $\alpha$ bits et valeurs de syndrome souple et $\beta$ bits et valeurs de syndrome souple correspondent à une partie codée, respectivement non codée, ces nombres $\alpha$ et $\beta$ étant représentatifs du mode de codage possible utilisé, à maximiser cette valeur de vraisemblance en fonction de l'un des nombres représentatifs du mode de codage possible utilisé, ce qui permet de détecter le mode de codage effectivement utilisé pour la transmission de ces données numériques pour la valeur maximum de cette valeur de vraisemblance.

Le procédé, objet de la présente invention, trouve application à la transmission de données numériques par paquets sur un canal présentant des caractéristiques variables dans le temps, tel que les canaux radioélectriques hertziens ou satellitaires.

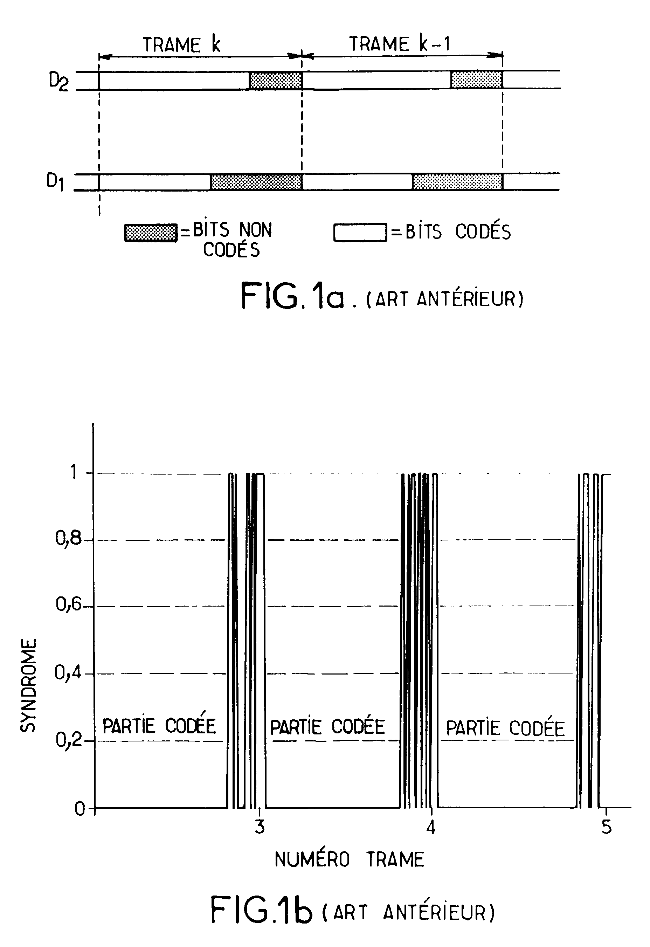

Il sera mieux compris à l'observation des dessins ci-après dans lesquels, outre les figures 1a et 1b relatives à l'art antérieur :

-   la figure 2 représente un organigramme général des étapes permettant la mise en oeuvre du procédé de détection en aveugle du mode de codage de données numériques objet de la présente invention ;
-   la figure 3a représente un opérateur de calcul de valeur de syndrome souple, produit de deux valeurs de Log-vraisemblance $L_1$ et $L_2$ ;

- la figure 3b représente un graphe de calcul de valeurs de syndrome souple dans le cas donné à titre d'exemple non limitatif d'un codage convolutif de rendement R = 1/2 à partir de polynômes générateurs spécifiques ;
- la figure 3c représente pour des trames successives les valeurs de syndrome souple obtenues pour un canal blanc Gaussien, lorsque le codage convolutif utilisé est celui qui est représenté en figure 3b ;
- la figure 4 représente, à titre illustratif, un histogramme des valeurs de syndrome souple pour les parties codées et non codées de trames successives, pour une valeur déterminée du rapport signal à bruit du signal numérique support de ces trames ;
- la figure 5 représente un diagramme du taux de détection erronée du code convolutif choisi parmi un nombre déterminé de codes convolutifs possibles égal à 2, en fonction de la valeur du rapport signal à bruit du signal numérique.

Préalablement à la description proprement dite du procédé de détection en aveugle du mode de codage de données numériques, objet de la présente invention, différents éléments techniques relatifs au processus de codage convolutif et à la mise en oeuvre de la mise en évidence d'erreurs de transmission par le calcul d'un syndrome d'erreur seront tout d'abord donnés en liaison avec les figures 1a et 1b.

En référence à la figure la, on rappelle que les processus de codage convolutif actuellement utilisés présentent la forme suivante :

Les données numériques à coder arrivent par paquets de longueur $L = n_1 + n_2$ bits. Ces données sont séparées en deux parties, les $n_1$ premiers bits, éventuellement complétés par un certain nombre de bits à la valeur 0 appelés bits de queue ou *tail bits* en langage anglo-saxon, sont protégés par un processus de codage convolutif, lequel, à titre d'exemple non limitatif et de simplification, est supposé de rendement R = 1/2. Les $n_2$ bits restants du paquet ne sont pas soumis au processus de codage. Les bits codés sont transmis avant les bits non codés.

Les bits transmis, désignés par trames, sont constitués par une succession alternée de bits issus du codeur convolutif et de bits qui n'ont pas été soumis au processus de codage et ne sont donc pas protégés par ce dernier. Chaque trame présente un motif périodique de longueur $P = 2n_1 + n_2$ dans le cas où aucun bit complémentaire ou *tail bit* n'a été ajouté, respectivement $P = 2(n_1 + K) + n_2$ lorsque l'on a ajouté un nombre K de *tail bits,* la valeur de K étant déterminée par le degré des polynômes générateurs du code convolutif.

En référence à trois modes de codage convolutif possibles, pour une version demi-débit d'un codeur de parole GSM, les débits respectifs $D_1 = 7,8$, $D_2 = 6,5$ et $D_3 = 5$ kbits/s, trois modes de codage convolutif peuvent par exemple consister en :

- 64 bits codés 1/2, 92 bits non codés avec un débit $D_1$ ;
- 90 bits codés 1/2, 40 bits non codés avec un débit $D_2$ ;
- 20 bits codés 1/3, 80 bits codés 1/2 avec un débit $D_3$.

Dans les trois exemples de codage convolutif précités constituant un nombre fini de possibilités de codage utilisé, on remarque la part croissante attribuée au codage de canal quand on passe du débit $D_1$ au débit $D_3$. Les deux premiers exemples de débit $D_1$ et $D_2$ correspondent à un codage convolutif de rendement 1/2.

En référence aux exemples de mode de codage susceptibles d'être utilisés, pour les deux premiers débits $D_1$ et $D_2$ et pour la transmission d'un signal de parole GSM demi débit, le code convolutif de rendement 1/2 a pour polynômes générateurs :

- $G_1 = 1 + D^3 + D^4$
- $G_2 = 1 + D + D^3 + D^4$.

Dans le présent exemple, le degré des polynômes générateurs est K=4. Dans le cas où des *tails bits* sont ajoutés aux bits codés, la période P est la même dans les deux cas, c'est-à-dire pour les débits $D_1$ et $D_2$ précités. La période a pour valeur :

$$P = 2 \times (64+4) + 92 = 2 \times (90+4) + 40 = 228 \text{ bits}$$

ainsi que représenté en figure 1a.

Lorsqu'aucune erreur de transmission n'affecte les trames codées selon l'un des modes de codage représenté en figure la par exemple, un décodeur de code convolutif utilisé à la réception voit dans ce cas arriver alternativement des bits qui proviennent du codeur correspondant sans aucune erreur et des bits qui ne proviennent pas de ce codeur et qui, en conséquence, peuvent être considérés comme transmis avec un taux d'erreur p = 1/2.

Ces deux situations distinctes sont suffisamment contrastées pour être discriminées à la réception. Cette discrimination peut être effectuée sans que le processus de décodage soit mis en oeuvre, au moyen du calcul d'une valeur de syndrome d'erreur, ce syndrome d'erreur étant une valeur associée aux bits reçus et représentative de la probabilité d'erreur de transmission. Cette valeur de syndrome d'erreur est ci-après désignée comme valeur de syndrome dur et sera explicitée ci-après.

Pour $\{x_0, x_1, ...x_n\}$ constituant une suite de bits à l'entrée du processus de codage convolutif de polynômes générateurs vérifiant la relation :

$$G_1(D) = \sum_{i=0}^{K} G_{1,i} D^i, \quad G_2(D) = \sum_{i=0}^{K} G_{2,i} D^i$$

la suite des bits codés obtenue après mise en oeuvre du processus de codage s'écrit :

$$Y(D) = \begin{pmatrix} Y_1(D) \\ Y_2(D) \end{pmatrix} = X(D) \begin{pmatrix} G_1(D) \\ G_2(D) \end{pmatrix}$$

$$X(D) = \sum_{n \geq 0} x_n D^n$$

La valeur de syndrome dur est définie par la relation :

$$S(D) = Y_1(D)G_2(D) \oplus Y_2(D)G_1(D)$$

Le symbole $\oplus$ désigne l'opération OU exclusif.

Cette valeur de syndrome dur est nulle lorsqu'il n'existe aucune erreur de transmission. Dans le cas contraire, si l'on désigne par $E_1(D)$ et $E_2(D)$ les erreurs binaires sur les deux trains de bits issus du processus de codage convolutif et de la transmission, chaque train de bits étant engendré par l'un des polynômes générateurs, alors, la valeur de syndrome dur précédemment mentionnée n'est plus nulle et indique l'existence d'erreurs de transmission, cette valeur, pour cette raison, étant désignée par valeur de syndrome dur.

Selon une propriété des valeurs de syndrome dur, on indique que la valeur de syndrome ne dépend que des erreurs binaires introduites sur les deux trains de bits obtenus. Pour les erreurs $E_1(D)$ et $E_2(D)$ précédemment citées, la valeur de syndrome dur vérifie la relation (1) :

$$S(D) = E_1(D)G_2(D) \oplus E_2(D)G_1(D) \tag{1}$$

La valeur de syndrome dur pour une suite de n bits successifs vérifie alors la relation (2) :

$$s_n = \sum_{i=0}^{K} E_{n-i}^{(1)} G_{2,i} \oplus \sum_{i=0}^{K} E_{n-i}^{(2)} G_{1,i} = u \oplus v \tag{2}$$

Cette valeur de syndrome est représentée par le produit OU exclusif de la somme de w' termes d'erreurs, où w' désigne le nombre de coefficients non nuls du polynôme $G_2(D)$, et de w" termes d'erreurs, où w" désigne le nombre de coefficients non nuls du polynôme $G_1(D)$, ces termes d'erreurs étant respectivement désignés par u et v, ainsi que représenté en relation (2).

On rappelle que w' et w" désignent le poids de Hamming du polynôme générateur $G_2(D)$ et du polynôme générateur $G_1(D)$ respectivement.

Il est alors possible de calculer les probabilités $p_1$ et $p_2$ pour que les sommes de termes d'erreurs u et v soient non nulles.

Ces probabilités s'écrivent :

$$p_1 = \Pr[u \neq 0] = \sum_{i \text{ impair}} C_{w'}^i \ p^i (1-p)^{w'-i}$$

$$p_2 = \Pr[v \neq 0] = \sum_{i \text{ impair}} C_{w''}^i \ p^i (1-p)^{w''-i}$$

En référence au principe des probabilités totales, la probabilité pour que la valeur de syndrome dur $s_n$ soit différente de 0 est donnée par la relation (3) :

$$\Pr(s_n \neq 0) = p_1(1 - p_2) + p_2(1 - p_1) \qquad (3)$$

Lorsque le taux d'erreur p dans le canal de transmission est très petit, on peut écrire :

$$p_1 \approx w'p, p_2 \approx w''p \Rightarrow \Pr(s_n \neq 0) \approx (w'+w'')p$$

Lorsque le taux d'erreur dans le canal est voisin de 1/2, p = 1/2, alors, $p_1 = p_2 = 1/2$ et la probabilité pour que la valeur de syndrome soit différente de 0 est égale à 1/2. Ainsi, il apparaît que l'élément distinctif des parties codées et non codées du flux de bits transmis est constitué par la proportion de bits de syndrome dur non nuls, laquelle est égale à ½ dans la partie non codée, ainsi que représenté en figure 1b.

Ainsi, lorsque la qualité du canal de transmission est bonne, c'est-à-dire pour un taux d'erreur p très inférieur à 1, les zones codées et non codées sont très nettement distinctes au seul examen de la valeur du syndrome dur précité. Il n'en est toutefois plus de même dans un canal de médiocre qualité comme par exemple un canal de transmission radioélectrique tel que le radiotéléphone mobile, où le taux d'erreur binaire est de l'ordre de quelque pour cents. Dans une telle situation, la probabilité d'obtenir un bit de syndrome non nul devient vite voisine de la valeur 0,5, cette probabilité étant de la forme : (w'+w'')p où w' et w'' représentent les poids de Hamming des polynômes générateurs précédemment mentionnés. Pour le processus de codage mentionné en exemple précédemment dans la description, le résultat est de l'ordre de 7p et atteint une valeur voisine de 35% si p = 0,05, une telle valeur de probabilité d'erreur étant courante dans ce type de canal de transmission. Dans un tel cas, la discrimination d'un mode de codage convolutif, à partir de la valeur de syndrome dur, apparaît particulièrement délicate et ne peut donc être facilement mise en oeuvre.

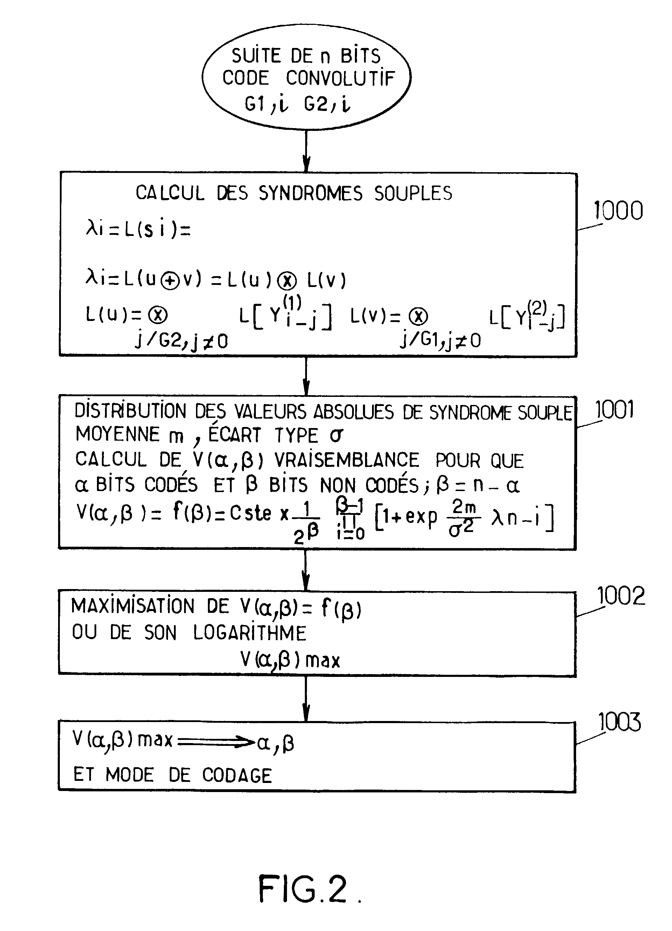

Le procédé, objet de la présente invention, dans lequel une telle difficulté est supprimée, sera maintenant décrit en liaison avec la figure 2.

D'une manière générale, on indique que le procédé objet de la présente invention, peut être mis en oeuvre sur une suite de bits et en particulier sur chaque trame de n bits précédemment mentionnée dans la description. Le procédé, objet de la présente invention, afin de supprimer l'ambiguïté précitée, permet d'obtenir une information sur la fiabilité des bits de syndrome obtenus.

Ainsi que représenté à la figure 2 précitée, il consiste pour chaque suite de bits considérée à calculer la valeur d'un syndrome souple, à l'étape 1000, cette valeur de syndrome souple représentant la vraisemblance de la valeur de syndrome dur précédemment mentionnée dans la description.

Ainsi, pour toute valeur x à l'entrée du canal de transmission, et pour toute valeur y à la sortie correspondante du démodulateur, c'est-à-dire à la réception, étant précisé que le démodulateur délivre des valeurs réelles en sortie, la vraisemblance logarithmique désignée par Log-vraisemblance de la valeur du bit x conditionnelle à la valeur réelle, désignée par L(x|y), y est donnée par la relation :

$$L(x|y) = \ln \frac{\Pr(x = 1|y)}{\Pr(x = 0|y)}$$

Cette valeur de Log-vraisemblance est définie comme le logarithme népérien du rapport de la probabilité conditionnelle de la valeur du bit x=1 conditionnelle à la valeur y à la probabilité conditionnelle de la valeur du bit x=0 conditionnelle à cette même valeur y.

Une telle valeur de Log-vraisemblance est une grandeur réelle dont le signe, positif ou négatif, permet de prendre une décision ferme relativement à la valeur du bit, c'est-à-dire x=0 ou bien x=1. Toutefois, l'opération de décision précitée a pour conséquence la perte d'une information importante donnée par la valeur absolue de la Log-vraisemblance, laquelle indique si les deux probabilités conditionnelles sont voisines, auquel cas la décision présente une faible fiabilité, la valeur de la Log-vraisemblance $L(x|y)$ étant voisine de 0 ou très différente pour une forte fiabilité de cette décision lorsque $|L(x|y)|$ est très grande.

L'inversion de la relation précédente permet d'écrire et d'exprimer la probabilité de la valeur du bit x égale à la valeur 1 conditionnelle à la valeur réelle y ainsi que de la probabilité de cette même valeur du bit x égale à la valeur 0 conditionnelle à cette même valeur y selon la relation :

$$\Pr(x = 1|y) = \frac{e^{L(x|y)}}{1 + e^{L(x|y)}} , \qquad \Pr(x = 0|y) = \frac{1}{1 + e^{L(x|y)}}$$

En outre, si $x_1$ et $x_2$ sont deux valeurs de bits successifs transmis et de Log-vraisemblance respective notée $L_1$ et $L_2$ par rapport aux sorties correspondantes du démodulateur, la valeur de la Log-vraisemblance du produit OU exclusif des valeurs de bit $x_1$ et $x_2$, valeurs $z = x_1 \oplus x_2$, vérifie la relation :

$$\Pr(z = 1) = \Pr(x_1 = 1)\Pr(x_2 = 0) + \Pr(x_1 = 0)\Pr(x_2 = 1)$$

$$= \frac{e^{L1} + e^{L2}}{(1 + e^{L1})(1 + e^{L2})}$$

La valeur de Log-vraisemblance de z produit OU exclusif des deux bits successifs $x_1$ et $x_2$ conditionnelle aux valeurs $y_1$ et $y_2$ en sortie du démodulateur vérifie alors la relation (4) :

$$z = x_1 \oplus x_2 \Rightarrow L(z) = L_1 \otimes L_2 = \ln \frac{e^{L1} + e^{L2}}{1 + e^{L1}e^{L2}} \qquad (4)$$

Dans la relation précédente, le signe $\otimes$ indique le produit des valeurs de Log-vraisemblance $L_1$ et $L_2$ pour les valeurs de bits correspondantes $x_1$ et $x_2$.

Par la transformation $\tanh \frac{z}{2} = \frac{e^z - 1}{e^z + 1}$, la relation (4) précédente s'écrit selon la relation (5) :

$$\tanh\left[\frac{L(x_1 \oplus x_2)}{2}\right] = -\tanh\left[\frac{L(x_1)}{2}\right]\tanh\left[\frac{L(x_2)}{2}\right] \qquad (5)$$

La relation (5) précédente permet d'établir une approximation de la valeur de la Log-vraisemblance de z produit OU exclusif des deux valeurs de bits $x_1$ et $x_2$, cette approximation vérifiant la relation (6):

$$L(z) \approx -\text{sgn}[L(x_1)] \times \text{sgn}[L(x_2)] \times \min[|L(x_1)|, |L(x_2)|] \qquad (6)$$

Dans cette relation, le symbole sgn indique le signe de l'expression entre crochets, et le symbole min désigne la valeur minimum entre deux valeurs entre crochets, c'est-à-dire entre les valeurs absolues des Log-vraisemblances $L(x_1)$ et $L(x_2)$ des valeurs de bits successives $x_1$ et $x_2$.

Les relations (5) et (6) précédentes permettent d'établir par itération que la valeur de Log-vraisemblance précitée peut être calculée pour un produit OU exclusif d'un nombre quelconque de valeurs de bits successives $x_i$.

Ainsi, pour une suite quelconque de bits de valeurs $x_1$ à $x_n$ constituée par exemple par une trame du signal de parole transmis, les relations ci-après sont obtenues :

$$\tanh\left[\frac{L(x_1 \oplus x_2 \oplus \ldots x_n)}{2}\right] = (-1)^{n-1} \prod_{i=1}^{n} \tanh\left[\frac{L(x_1)}{2}\right]$$

$$L(x_1 \oplus x_2 \oplus \ldots x_n) = L(x_1) \otimes L(x_2) \ldots \otimes L(x_n) = \overset{n}{\underset{i=1}{\otimes}} L(x_1)$$

$$L(x_1 \oplus x_2 \oplus \ldots x_n) \approx (-1)^{n-1} \prod_{i=1}^{n} \mathrm{sgn}[L(x_1)] \times \min_{i}\left\{L(x_i)\right\}$$

Dans les relations précédentes, le symbole $\min_i$ représente la valeur minimum de la valeur absolue des Log-vraisemblances de chaque bit $x_i$ de la suite de bits considérée.

L'expression des Log-vraisemblances de produit de OU exclusif encore désignée somme modulo 2 de valeur binaire ou bit $x_i$ successifs et les considérations précédentes permettent de calculer les valeurs de syndrome souple en appliquant la relation (2) précédemment mentionnée dans la description en sortie du démodulateur en considérant que la valeur de syndrome souple correspond à la vraisemblance du syndrome dur, vraisemblance exprimée sous forme de Log-vraisemblance de la valeur de syndrome dur.

Compte tenu des considérations précédentes, la valeur de syndrome souple, valeur de Log-vraisemblance du syndrome dur, vérifie la relation (7) :

$$L(s_n) = L(u \oplus v) = L(u) \otimes L(v)$$

$$L(u) = \underset{i/G2, i\neq 0}{\otimes} L\left[Y_{n-i}^{(1)}\right] \qquad\qquad (7)$$

$$L(v) = \underset{i/G1, i\neq 0}{\otimes} L\left[Y_{n-i}^{(2)}\right]$$

Bien entendu, dans la relation (7) précédente, u et v désignent la somme des w' et w" termes d'erreurs de la relation (2). Ainsi, la Log-vraisemblance du syndrome dur $L(S_n)$ égale à la Log-vraisemblance du produit OU exclusif des sommes de w' et w" des termes d'erreurs u et v est égale au produit des Log-vraisemblances de ces mêmes sommes de termes d'erreurs $L(u)$ et $L(v)$, la notion de produit étant bien entendu celle qui correspond au produit des tangentes hyperboliques ou, le cas échéant, selon l'approximation précédemment mentionnée dans la description prenant en compte le signe des Log-vraisemblances et la valeur minimale de la valeur absolue de ces mêmes Log-vraisemblances.

Dans la relation (7) précédente, on indique en outre que les symboles $i|G_{2,i\neq 0}$ et $i|G_{1,i\neq 0}$ désignent les coefficients non nuls des polynômes générateurs $G_2(D)$ et $G_1(D)$ du codage convolutif, $Y_{n-i}^{(1)}$ et $Y_{n-i}^{(2)}$ désignent la valeur des bits successifs codés de rang n-i correspondant.

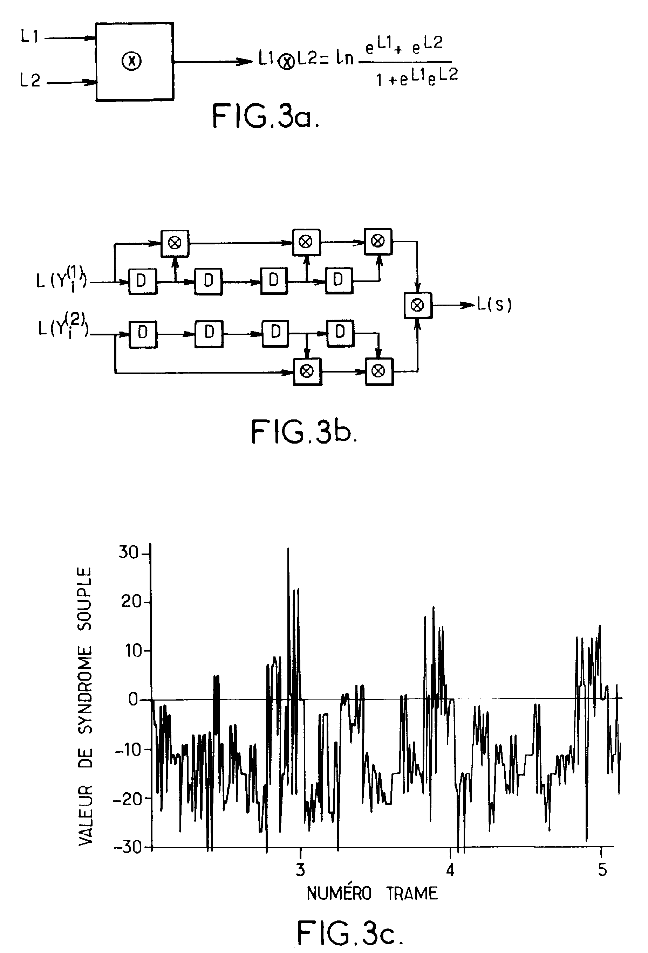

Le calcul des valeurs de syndrome souple peut être effectué par l'intermédiaire d'un opérateur, tel que représenté en figure 3a, réalisant l'opération indiquée selon la relation (4) sur deux valeurs de bits successives, $x_1$ et $x_2$, ou le cas échéant par la relation (6) selon l'approximation mentionnée précédemment dans la description. Dans les deux cas, cet opérateur est désigné par le symbole $\otimes$, cet opérateur faisant correspondre à toute variable à l'entrée $L(x_1)$, $L(x_2)$ la valeur du produit des Log-vraisemblances $L_1$ et $L_2$ selon la relation (4) ou le cas échéant l'approximation selon la relation (6).

Un exemple de mise en oeuvre de ces opérateurs pour un processus de codage convolutif de rendement R = 1/2 de polynôme générateur $G_1 = 1+D^3+D^4$ et $G_2 = 1+D^3+D^4$ est représenté en figure 3b. Sur la figure précitée, on indique que chaque valeur de D indique la valeur correspondante de la variable réelle du polynôme générateur $G_1$ ou $G_2$, l'opérateur de multiplication étant introduit conformément à la représentation précédemment mentionnée dans la description en figure 3a.

La figure 3c représente le résultat des valeurs de syndrome souple pour le codage convolutif réalisé en figure 3b dans un canal blanc Gaussien tel qu'un canal de transmission radioélectrique par exemple. Les valeurs de syndrome souple sont portées en ordonnées, valeurs positives et négatives, et les valeurs de numéro de trame sont portées en abscisses, les valeurs de syndrome souple étant représentées sur trois trames consécutives.

Conformément à la définition des valeurs de syndrome souple précédemment donnée dans la description, les valeurs négatives de syndrome souple correspondent à des décisions fermes $x_i = 0$. A l'observation de la figure 3c, on constate que l'on retrouve bien les régions de trames non codées pour lesquelles les valeurs de syndrome souple sont positives. Toutefois, selon un aspect remarquable du procédé, objet de la présente invention, les valeurs de syndrome positives qui se trouvent dans la partie codée de la trame ont une amplitude sensiblement plus faible que les erreurs de la partie non codée.

La constatation précédente peut alors, conformément à un aspect particulièrement avantageux du procédé, objet de la présente invention, être exploitée en une étape 1001 représentée en figure 2, au cours de laquelle, à partir de la distribution des valeurs de syndrome souple, cette distribution présentant une valeur moyenne m et un écart type σ, il est procédé à un calcul de la vraisemblance $V(\alpha,\beta)$ pour que α bits de chaque trame considérée soient codés et β bits de cette même trame soient non codés.

D'une manière générale, on indique que la valeur moyenne m et l'écart type σ de la distribution des valeurs de syndrome souple peuvent être calculés à partir des valeurs mémorisées de syndrome souple pour chaque bit $x_i$ constitutif de la suite de bits.

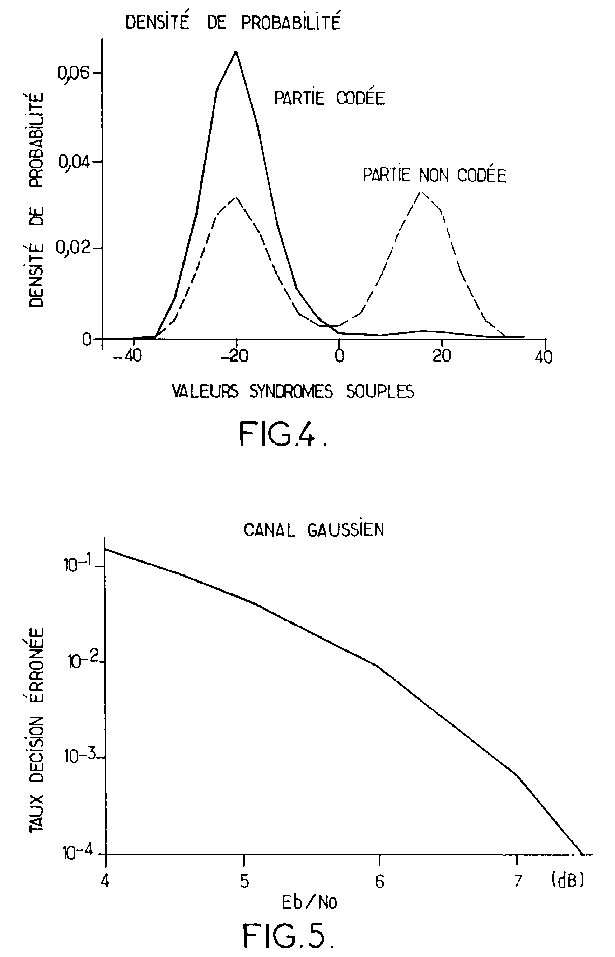

Afin d'illustrer de manière plus concrète le mode opératoire de l'étape 1001 précitée, et bien que l'établissement d'un histogramme des valeurs de syndrome souple ne soit pas nécessaire, on a représenté, à titre purement illustratif, un tel histogramme des valeurs de syndrome souple en figure 4. A l'observation de la figure précitée, on constate que chaque histogramme des valeurs de syndrome souple correspond soit à une loi Gaussienne ou sensiblement Gaussienne centrée autour d'une valeur négative pour la partie codée, la valeur -20 sur la figure 4, ou une superposition de deux lois sensiblement Gaussiennes de valeurs moyennes opposées pour la partie non codée. L'observation de la répartition précitée des valeurs de syndrome souple pour les parties codées et non codées permet de discriminer la proportion de bits qui avaient été codés par codage convolutif dans la trame, et ainsi de déterminer le mode de codage effectivement utilisé. Sur la figure 4, on rappelle que la densité de probabilité est portée en ordonnées et que la valeur des syndromes souples, valeur réelle, est portée en abscisses, la partie codée étant représentée en trait continu et la partie non codée en trait pointillé.

Les lois respectives de distribution des valeurs de syndrome souple pour les parties codées et non codées sont de la forme $N(x,-m,\sigma)$ pour la partie codée et $\frac{1}{2}[N(x-m,\sigma)+N(x+m,\sigma)]$ pour la partir non codée où m est la valeur absolue de la valeur moyenne et

$$N(x;m,\sigma) = \frac{1}{\sigma\sqrt{2\pi}}\, e^{\frac{(x-m)^2}{2\sigma^2}}$$

est la loi normale ou Gaussienne de moyenne m et d'écart type σ. Les paramètres de moyenne et d'écart type σ peuvent être mesurés à partir des valeurs mémorisées de syndrome souple, ainsi qu'il sera décrit ultérieurement dans la description relativement à l'identification des paramètres d'un mélange de lois Gaussiennes.

L'étape 1001 consiste alors, à partir des paramètres de valeur moyenne m et d'écart type σ précités, à calculer une vraisemblance de la suite observée de syndromes souples pour que α bits soient codés et β bits soient non codés, cette valeur de vraisemblance étant notée à titre de simplification $V(\alpha,\beta)$. Afin de simplifier la notation, on désigne par $\lambda_i = L(S_i)$ avec i = 1 à n, les valeurs de syndrome souple en sortie du système d'opérateur tel que représenté en figure 3a, ce système pouvant comporter toutefois des polynômes générateurs quelconques et n'étant pas de ce fait limité au mode de réalisation de la figure 3a. Dans l'hypothèse où α syndromes souples correspondent à une partie codée et $\beta = n-\alpha$ syndromes correspondent à une partie non codée, la vraisemblance de la suite observée de syndromes souples $V(\alpha,\beta)$ vérifie la relation :

$$\Pr\left[\{\lambda_i\}|\alpha\right] = \prod_{i=1}^{\alpha} N(\lambda_i;-m) \times \prod_{i=0}^{\beta-1} \frac{1}{2}\left[N(\lambda_{n-i};-m) + N(\lambda_{n-i};m)\right]$$

$$= \prod_{i=1}^{n} N(\lambda_i;-m) \times \frac{1}{2^{\beta}} \prod_{i=0}^{\beta-1}\left[1 + \frac{N(\lambda_{n-i};m)}{N(\lambda_{n-i};-m)}\right]$$

D'une manière générale, on indique que la vraisemblance de la suite observée de syndromes souples V(α, β) correspond en fait à la probabilité de la suite des i=1 à n valeurs de syndrome souple, conditionnelles à la valeur α.

Cette probabilité est égale au produit des densités de probabilité des valeurs de syndrome souple $\lambda_i$ pour la partie codée, densités de probabilité déterminées pour i=1 à α selon la loi normale N($\lambda_i$,-m) par le produit des densités de probabilités des β syndromes souples selon la loi normale 1/2 [N($\lambda_{n-i}$, -m)+N($\lambda_{n-i}$,m)].

Le remplacement dans la relation précédente de la valeur de densité de probabilité par sa valeur en fonction des lois de distribution selon les lois normales précitées permet d'obtenir la valeur de la vraisemblance de la suite observée de syndromes souples vérifiant la relation (8) :

$$V(\alpha,\beta) = f(\beta) = \Pr[\{\lambda_i\}|\beta] = Cste \times \frac{1}{2^\beta} \prod_{i=0}^{\beta-1}\left[1 + \exp\left(\frac{2m}{\sigma^2}\lambda_{n-i}\right)\right] \; ; \; \beta = n - \alpha \qquad (8)$$

Dans cette relation (8) on indique que la valeur de la vraisemblance a été ramenée à la fonction du seul paramètre β en raison de la dépendance linéaire entre β, α et n, β = n-α.

L'étape 1001 précitée est alors suivie d'une étape 1002, tel que représenté en figure 2, consistant à maximiser la valeur de la vraisemblance de la suite observée de syndromes souples en fonction du paramètre α ou du paramètre β compte tenu de l'indication précédente.

En effet, en raison du fait que l'on se trouve en présence d'un nombre fini de possibilités de modes de codage, les trois modes de codage selon les débits $D_1$, $D_2$, $D_3$ indiqués précédemment dans la description, lesquels correspondent à trois valeurs possibles de nombres de bits non codés $\beta_1$, $\beta_2$, $\beta_3$ et de valeurs de syndromes souples correspondants, l'opération de maximisation de la valeur de vraisemblance consiste alors à choisir la valeur de β parmi les valeurs $\beta_1$, $\beta_2$, $\beta_3$ qui maximisent la valeur de vraisemblance V(α,β) = f(β) où le cas échéant son logarithme.

Le logarithme de la valeur précitée vérifie alors la relation (9) :

$$\log[f(\beta)] \quad = \quad Cste + \sum_{i=0}^{\beta-1}\log\left[1 + \exp\left(\frac{2m}{\sigma^2}\lambda_{n-i}\right)\right] - \beta \times \log(2) \qquad (9)$$

Le critère de décision relatif à la valeur de β choisi correspond à celle qui maximise la valeur de f(β) ou de son logarithme, selon la relation (10) :

$$\hat{\beta} = \beta_i \Leftrightarrow \log[f(\beta_j)] < \log[f(\beta_i)] \quad \forall j \neq i \qquad (10)$$

Dans cette relation, $\beta_i$ désigne la valeur choisie et $\beta_j$ désigne toute valeur de β appartenant à l'ensemble des valeurs de β, c'est-à-dire à l'ensemble des valeurs de codage différentes de la valeur $\beta_i$.

Sur la figure 5, on a représenté le résultat d'une simulation de mise en oeuvre du procédé objet de la présente invention, pour deux codes possibles à discriminer. Le résultat affiché est un taux de décision erroné correspondant à une probabilité de décision erronée, une décision erronée correspondant au mauvais choix du mode de codage effectivement utilisé, en fonction du rapport signal à bruit du signal de parole. L'axe des ordonnées est gradué en valeurs de pourcentage et l'axe des abscisses en valeurs de rapport signal à bruit en décibels.

A l'observation de la figure 5, on constate que le procédé objet de la présente invention peut parfois conduire à l'obtention d'une décision erronée lorsque le rapport signal à bruit est faible. Le décodage correspondant en cas de décision erronée engendre donc un résultat nécessairement faux, ne serait ce qu'en observant l'évolution de la plus petite métrique du décodeur de Viterbi du codeur de canal. Dans une telle situation, il est possible de déclarer la trame reçue mauvaise, selon le message BFI : *Bad Frame Indication*. Toutefois, ce résultat peut être anticipé car dans un tel cas, les hypothèses considérées ont des valeurs de vraisemblances voisines, le choix étant alors entaché d'une grande incertitude et l'existence d'un résultat faux pouvant alors être prévue.

Différents rappels de modes opératoires concernant la détermination des paramètres de moyenne et d'écart type de lois de probabilité constituées par des mélanges de lois Gaussiennes seront donnés ci-après :

Pour une variable aléatoire Gaussienne x de moyenne m et de variance $\sigma^2$, la loi de probabilité est notée :

$$p_x(x) = N(x;m,\sigma) = \frac{1}{\sigma\sqrt{2\pi}}\, e^{\frac{(x-m)^2}{2\sigma^2}}$$

On vérifie alors que la loi de probabilité de Y = |x| est donnée par :

$$p_Y(y) = \begin{cases} 0 & ,\, y < 0 \\ p_x(y) + p_x(-y), & y \geq 0 \end{cases}$$

Compte tenu du fait que :

$$N(-x;m,\sigma) = N(x;-m,\sigma)$$
$$y \geq 0 \Rightarrow p_y(y) = N(y,-m,\sigma) + N(y;+m,\sigma)$$

Lorsque la variable aléatoire x est un mélange de deux lois Gaussiennes de même variance mais de moyennes opposées, donc de loi :

$$p_x(x) = \lambda N(x,m,\sigma) + (1 - \lambda)N(x,-m,\sigma)$$

où $0 \leq \lambda \leq 1$, alors la loi de probabilité y = |x| est encore donnée par la même expression :

$$p_Y(y) = \begin{cases} 0 & ,\, y < 0 \\ \dfrac{1}{\sigma\sqrt{2\pi}}\left\{ e^{\frac{(y-m)^2}{2\sigma^2}} + e^{\frac{(y+m)^2}{2\sigma^2}} \right\}, & y \geq 0 \end{cases}$$

Cette loi s'écrit aussi sous la forme suivante, pour $y \geq 0$ :

$$p_Y(y) = \frac{1}{\sigma}\sqrt{2/\pi}\, e^{\frac{x^2+m^2}{2\sigma^2}} \cosh\left(\frac{my}{\sigma^2}\right)$$

En conséquence, la loi de probabilité de la valeur absolue de deux Gaussiennes de moyennes opposées et de même variance ne dépend pas de la proportion $\lambda$ du mélange.

La propriété précédente est mise à profit ci-après pour identifier m, qu'on suppose > 0, et la variance. Pour $\{x_1, x_2, ..., x_n\}$ l'ensemble de la loi X, et $\{y_1 = |x_x|,..., y_n = |x_n|\}$ les valeurs absolues de ces échantillons. On recherche donc les paramètres m et $\sigma$ qui maximisent la quantité suivante :

$$\Pr\big[\{y_i\}\big|m,\sigma\big] = \prod_{i=1}^{n} \Pr\big[y_i\big|m,\sigma\big]$$

c'est-à-dire, relation (11) :

$$\Pr\big[\{y_i\}\big|m,\sigma\big] = \prod_{i=1}^{n} \frac{1}{\sigma}\sqrt{2/\pi}\, e^{-\frac{y_i^2+m^2}{2\sigma^2}} \cosh\left(\frac{my_i}{\sigma^2}\right)$$

La relation précédente fait intervenir un produit de cosinus hyperboliques. On sait que :

$$\cosh(a)\cosh(b)$$

$$= \frac{1}{2}\left[\cosh(a+b)+\cosh(a-b)\right]$$

$$= \frac{1}{4}\left[\cosh(a+b)+\cosh(a-b)+\cosh(-a+b)+\cosh(-a-b)\right]$$

où on a utilisé le fait que $\cosh(x)$ est une fonction paire. On peut poursuivre et vérifier que :

$$\cosh(a)\cosh(b)\cosh(c)$$

$$=$$

$$\frac{1}{8}\begin{bmatrix}\cosh(a+b+c)+\cosh(a+b-c)+\cosh(a-b+c)\\ +\cosh(a-b-c)+\cosh(-a+b+c)+\cosh(-a+b-c)\\ +\cosh(-a-b+c)+\cosh(-a-b-c)\end{bmatrix}$$

où les huit combinaisons signées $\pm a \pm b \pm c$ sont prises en compte. Par récurrence, on établit ainsi :

$$\prod_{i=1}^{n}\cosh(x_1) = \frac{1}{2^n}\sum\cosh(\pm x_1 \pm x_2 \ldots \pm x_n)$$

où la somme est étendue à toutes les combinaisons de signes. Cette identité permet d'écrire la relation (11) sous la forme de la relation (12) :

$$\Pr\left[\{y_i\}\middle|m,\sigma\right] \approx (2/\pi)^{n/2}\,\sigma^{-n}\exp\left(-\frac{\sum_i\left(x_i^2+m^2\right)}{2\sigma^2}\right)\times\frac{1}{2^n}\sum\cosh\frac{m}{\sigma^2}\left(\pm x_1 \pm x_2 \ldots \pm x_n\right)$$

Le terme dominant de la somme de cosinus hyperboliques est obtenu pour la combinaison :

$$\operatorname{sgn}(x_1)x_1 + \ldots + \operatorname{sgn}(x_n)x_n = |x_1|+|x_2|+\ldots+|x_n|$$

de sorte que l'on peut approximer la relation (12) par :

$$\Pr[\{y_i\}|m,\sigma] \approx (2/\pi)^{n/2}\sigma^{-n}\exp\left(-\frac{\sum_i\left(x_i^2 + m^2\right)}{2\sigma^2}\right) \times \frac{1}{2^n} \times \exp\frac{m}{\sigma^2}\left(|x_1| + |x_2|...|x_n|\right)$$

Les paramètres m et σ qui rendent cette quantité maximale sont alors :

$$\begin{cases} m = \dfrac{1}{n}\sum_{i=1}^{n}|x_i| \\[2em] \sigma = \dfrac{1}{n}\sum_{i=1}^{n}\left(|x_i| - m\right)^2 \end{cases}$$

L'approximation précédente est ainsi justifiée.

L'identification de la proportion λ du mélange peut être effectuée à partir de la définition même du mélange :

$$p_x(x) = \lambda N(x,m,\sigma) + (1-\lambda)N(x,-m,\sigma)$$

La valeur moyenne de la variable aléatoire x est donnée par :

$$E[X] = \lambda m + (1-\lambda)(-m) = (2\lambda-1)m.$$

En conséquence, λ est déduit par :

$$\lambda = \frac{1}{2}\left(1 + \frac{E[X]}{m}\right) \approx \frac{1}{2}\left(1 + \frac{\sum_{i=1}^{n}x_i}{\sum_{i=1}^{n}|x_i|}\right)$$

dans le cas particulier où l'on doit décider si l'on est en présence d'un mélange équilibré, c'est-à-dire λ=0,5, ou d'un cas pur, λ=0 ou λ=1, il suffit de comparer λ aux seuils 0,25 et 0,75 :

$$\lambda = \begin{cases} 0, & \lambda < 0,25 \\ 0,25, & 0,25 \le \lambda < 0,75 \\ 1, & 0,75 \le \lambda \end{cases}$$

**Revendications**

1. Procédé de détection en aveugle d'un mode de codage de données numériques transmises par trames, chaque trame courante comportant n bits et consistant en un premier nombre déterminé de bits codés par codage convolutif et un deuxième nombre déterminé de bits non codés, le nombre de bits codés et le nombre de bits non codés définissant ledit mode de codage étant choisi parmi un ensemble fini de possibilités, caractérisé en ce que ce procédé consiste, pour au moins une trame transmise :

- à calculer sur une suite de bits une valeur de syndrome souple représentative de la probabilité d'erreur de transmission, pour les bits considérés ;
- à calculer, à partir des paramètres de moyenne et d'écart type de la distribution de ces valeurs de syndrome souple, une valeur de vraisemblance, fonction du nombre de bits codés $\alpha$ ou non codés $\beta=n-\alpha$, pour que $\alpha$ bits et valeurs de syndrome souple et $\beta$ bits et valeurs de syndrome souple correspondent à une partie codée respectivement non codée, lesdits nombres $\alpha$ ou $\beta$ étant représentatifs du mode de codage possible utilisé ;
- à maximiser ladite valeur de vraisemblance en fonction de l'un desdits nombres représentatifs du mode de codage possible utilisé, ce qui permet de détecter le mode de codage effectivement utilisé pour la transmission desdites données numériques pour la valeur maximum de ladite valeur de vraisemblance.

**2.** Procédé selon la revendication 1, caractérisé en ce que pour une suite de n bits successifs obtenus à partir de valeurs réelles en sortie du décodeur, ladite valeur de syndrome souple est définie par la vraisemblance du syndrome dur, la valeur de syndrome dur, pour cette suite de bits, étant définie comme le produit OU exclusif du produit des erreurs de transmission et des polynômes générateurs du codage convolutif.

**3.** Procédé selon la revendication 2, caractérisé en ce que ladite valeur de syndrome souple $L(s_n)$ vérifie la relation :

$$L(s_n) = L(u \oplus v) = L(u) \otimes L(v)$$

avec

$$L(u) = \underset{i \, / \, G_{2,i} \neq 0}{\otimes} L\!\left[Y_{n-i}^{(1)}\right]$$

$$L(v) = \underset{i \, / \, G_{1,i} \neq 0}{\otimes} L\!\left[Y_{n-i}^{(2)}\right]$$

où $L[Y_{n-i}^{(1)}]$ et $L[Y_{n-i}^{(2)}]$ désignent la Log-vraisemblance de deux valeurs de bits consécutives de cette suite de bits successifs et $G_{1,i\neq0}$ et $G_{2,i\neq0}$ désignent les coefficients non nuls des polynômes générateurs du codage convolutif.

**4.** Procédé selon l'une des revendications 1 à 3, caractérisé en ce que pour des lois respectives de distribution des valeurs de syndrome souple de la forme :

$$N(x,-m,\sigma) \text{ et } \frac{1}{2}\left[N(x;-m,\sigma)+N(x;+m,\sigma)\right]$$

pour la partie codée respectivement non codée où $N(x,m,\sigma)$ est une loi de distribution Gaussienne de la forme :

$$N(x;m,\sigma) = \frac{1}{\sigma\sqrt{2\pi}} \, e^{\frac{(x-m)^2}{2\sigma^2}}$$

de moyenne m et d'écart type $\sigma$, la valeur de vraisemblance de la suite de syndromes souples vérifie la relation :

$$f(\beta) = Cste \times \frac{1}{2^\beta} \prod_{i=0}^{\beta-1}\left[1 + \exp\!\left(\frac{2m}{\sigma^2}\lambda_{n-i}\right)\right]$$

où $\lambda_{n-i} = L(S_{n-i})$, i=1,2, ..., n.

TRAME k

TRAME k-1

D₂

D₁

░░░░ =BITS NON
CODÉS

▭ =BITS CODÉS

FIG.1a . (ART ANTÉRIEUR)

SYNDROME

1

0,8

0,6

0,4

0,2

0

PARTIE CODÉE

PARTIE CODÉE

PARTIE CODÉE

3

4

5

NUMÉRO TRAME

FIG.1b (ART ANTÉRIEUR)

SUITE DE n BITS
CODE CONVOLUTIF
$G1,i$   $G2,i$

CALCUL DES SYNDROMES SOUPLES

$\lambda i = L(s\,i) =$

$\lambda i = L(u \oplus v) = L(u) \otimes L(v)$

$L(u) = \underset{j/G2,\,j\neq 0}{\otimes} L\left[ Y^{(1)}_{i-j} \right]$   $L(v) = \underset{j/G1,\,j\neq 0}{\otimes} L\left[ Y^{(2)}_{i-j} \right]$

**1000**

DISTRIBUTION DES VALEURS ABSOLUES DE SYNDROME SOUPLE
MOYENNE $m$ , ÉCART TYPE $\sigma$
CALCUL DE $V(\alpha,\beta)$ VRAISEMBLANCE POUR QUE
$\alpha$ BITS CODÉS ET $\beta$ BITS NON CODÉS ; $\beta = n - \alpha$
$V(\alpha,\beta) = f(\beta) = C\,ste \times \dfrac{1}{2^{\beta}} \prod\limits_{i=0}^{\beta-1} \left[ 1 + \exp \dfrac{2m}{\sigma^2} \lambda n_{-i} \right]$

**1001**

MAXIMISATION DE $V(\alpha,\beta) = f(\beta)$
OU DE SON LOGARITHME
$V(\alpha,\beta)\,max$

**1002**

$V(\alpha,\beta)\,max \Longrightarrow \alpha, \beta$
ET MODE DE CODAGE

**1003**

# FIG.2.

$$L1 \otimes L2 = \ln \frac{e^{L1} + e^{L2}}{1 + e^{L1}e^{L2}}$$

FIG.3a.

$L(Y_i^{(1)})$

$L(Y_i^{(2)})$

$L(s)$

FIG.3b.

FIG.3c.

DENSITÉ DE PROBABILITÉ

**FIG.4.**

CANAL GAUSSIEN

**FIG.5.**

Office européen
des brevets

**RAPPORT DE RECHERCHE EUROPEENNE**

Numéro de la demande

EP 00 40 1522

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 230 003 A (DENT PAUL W  ET AL) 20 juillet 1993 (1993-07-20) * abrégé * * figures 1,3,5 * * colonne 1, ligne 61 - colonne 2, ligne 13 * * colonne 2, ligne 38 - ligne 39 * * colonne 5, ligne 9 - colonne 6 * --- | 1-4 | H03M13/35 H04L1/00 |
| A | WO 98 04047 A (ERICSSON TELEFON AB L M) 29 janvier 1998 (1998-01-29) * abrégé * * figure 1 * --- | 1-4 | |
| A | US 5 453 997 A (RONEY IV EDWARD M) 26 septembre 1995 (1995-09-26) * revendications 1-3 * --- | 1-4 | |
| A | US 5 566 206 A (BUTLER BRIAN K  ET AL) 15 octobre 1996 (1996-10-15) * abrégé * * colonne 1, ligne 63 - colonne 2, ligne 9 * * revendication 9 * --- | 1-4 | **DOMAINES TECHNIQUES RECHERCHES** (Int.Cl.7) H03M H04L |
| A | WO 95 15033 A (STEWART JOHN SIDNEY ;THOMSON CONSUMER ELECTRONICS (US)) 1 juin 1995 (1995-06-01) * abrégé * * page 3, ligne 14 - ligne 19 * * page 4, ligne 17 - ligne 18 * * page 6, ligne 9 - ligne 20 * * page 8, ligne 10 - ligne 33 * * figures 2,3 * --- -/-- | 1-4 | |

Le présent rapport a été établi pour toutes les revendications

| Lieu de la recherche | Date d'achèvement de la recherche | Examinateur |
|---|---|---|
| LA HAYE | 11 septembre 2000 | Berbain, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                                     
& : membre de la même famille, document correspondant

EPO FORM 1503 03.82 (P04C02)

**Office européen des brevets**

# RAPPORT DE RECHERCHE EUROPEENNE

Numéro de la demande

EP 00 40 1522

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | OHASHI M ET AL: "DEVELOPMENT OF A VARIABLE RATE SYNDROME SEQUENTIAL DECODER BASED ONA STACK ALGORITHM" PROCEEDINGS OF THE GLOBAL TELECOMMUNICATIONS CONFERENCE AND EXHIBITION(GLOBECOM),US,NEW YORK, IEEE, vol. -, 1989, pages 131-135, XP000012241 * le document en entier * ----- | 1-4 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| LA HAYE | 11 septembre 2000 | Berbain, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**                    EP 00 40 1522

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-09-2000

| Document brevet cité au rapport de recherche | | Date de publication | Membre(s) de la famille de brevet(s) | | Date de publication |
|---|---|---|---|---|---|
| US 5230003 | A | 20-07-1993 | CA | 2060862 A | 09-08-1992 |
| | | | GB | 2253123 A,B | 26-08-1992 |
| | | | HK | 1007843 A | 23-04-1999 |
| WO 9804047 | A | 29-01-1998 | US | 5757821 A | 26-05-1998 |
| | | | AU | 3790397 A | 10-02-1998 |
| | | | EP | 0914719 A | 12-05-1999 |
| US 5453997 | A | 26-09-1995 | CA | 2116736 A | 06-09-1994 |
| US 5566206 | A | 15-10-1996 | AT | 158910 T | 15-10-1997 |
| | | | AU | 683479 B | 13-11-1997 |
| | | | AU | 7113694 A | 17-01-1995 |
| | | | BR | 9406891 A | 26-03-1996 |
| | | | DE | 69405997 D | 06-11-1997 |
| | | | DE | 69405997 T | 09-04-1998 |
| | | | DK | 705512 T | 11-05-1998 |
| | | | EP | 0705512 A | 10-04-1996 |
| | | | ES | 2110248 T | 01-02-1998 |
| | | | FI | 956091 A | 16-02-1996 |
| | | | GR | 3025316 T | 27-02-1998 |
| | | | HK | 1002148 A | 12-02-1999 |
| | | | JP | 9501548 T | 10-02-1997 |
| | | | KR | 191295 B | 15-06-1999 |
| | | | SG | 48219 A | 17-04-1998 |
| | | | SI | 705512 T | 30-04-1998 |
| | | | WO | 9501032 A | 05-01-1995 |
| | | | US | 5774496 A | 30-06-1998 |
| | | | CN | 1108834 A | 20-09-1995 |
| | | | IL | 109842 A | 30-09-1997 |
| | | | MX | 9404610 A | 31-01-1995 |
| | | | ZA | 9404032 A | 09-03-1995 |
| WO 9515033 | A | 01-06-1995 | BR | 9307901 A | 27-08-1996 |
| | | | AU | 5674694 A | 13-06-1995 |
| | | | CN | 1111858 A | 15-11-1995 |
| | | | EP | 0730795 A | 11-09-1996 |
| | | | JP | 9505703 T | 03-06-1997 |
| | | | US | 5912907 A | 15-06-1999 |

EPO FORM P0460

Pour tout renseignement concernant cette annexe : voir Journal Officiel de l'Office européen des brevets, No.12/82